# EUROPÄISCHE PATENTSCHRIFT

(11) **EP 0 510 516 B1**
(45) Veröffentlichungstag und Bekanntmachung des Hinweises auf die Patenterteilung: **11.01.1995**
(21) Anmeldenummer: 92106571.0
(22) Anmeldetag: 16.04.1992
(51) Int. Cl.: G01D 5/34, G01D 5/26

(54) **Sensoranordnung auf einem Substrat mit einem elektrischen Verbindungselement und Verfahren zur Herstellung einer solchen Sensoranordnung**
Sensor device on a substrate with an electrical link element and procedure to fabricate such a device
Dispositif capteur sur un substrat avec élément de liaison électrique et procédé pour la réalisation d'un tel dispositif

(30) Priorität: 24.04.1991 DE 4113335
(43) Veröffentlichungstag der Anmeldung: 28.10.1992
(73) Patentinhaber: Dr. Johannes Heidenhain GmbH, D-83292 Traunreut (DE)
(72) Erfinder: Kraus, Heinz, W-8225 Traunreut (DE); Bayer, Erich, W-8223 Trostberg (DE)

(56) Entgegenhaltungen:
- GB-A- 2 088 048
- PATENT ABSTRACTS OF JAPAN vol. 9, no. 4 (E-288)10. Januar 1985 & JP-A-59154083

## Beschreibung

Die Erfindung betrifft eine Sensoranordnung auf einem Substrat mit einem elektrischen Verbindungselement gemäß dem Oberbegriff des Anspruches 1 und ein Verfahren zur Herstellung einer solchen Sensoranordnung.

Eine derartige Sensoranordnung wird insbesondere bei einer Positionsmeßrichtung zur Messung der Relativlage zweier Objekte eingesetzt, bei der die Meßteilung eines mit dem einen Objekt verbundenen Teilungsträgers von einer mit dem anderen Objekt verbundenen Abtasteinheit abgetastet wird. Die Sensoranordnung in der Abtasteinheit besteht dabei je nach dem Meßprinzip der Positionsmeßeinrichtung aus lichtelektrischen, induktiven, kapazitiven oder magnetischen Sensoren.

Aus der GB-A-20 88 048 ist eine solche Positionsmeßeinrichtung in Form einer lichtelektrischen Winkelmeßeinrichtung bekannt, bei der auf einem Silizium-Substrat lichtelektrische Sensoren in Form von Photoelementen ausgebildet sind. Das Substrat wird in einem Abstand von einer Leiterplatte mittels eines Rahmens gehalten, der ein elektrisches Verbindungselement mit Leiterbahnen enthält. Diese Leiterbahnen werden einmal mit Kontaktstellen der Sensoren und zum anderen mit Kontaktstellen der Leiterplatte durch Lötung verbunden.

Diese Sensoren der Sensoranordnung auf dem Substrat bestehen in der Regel aus einer planaren Struktur, wobei der maximale Abtastabstand der Oberfläche dieser Sensoren von der Oberfläche der Meßteilung in Abhängigkeit von der Gitterkonstanten der Meßteilung für eine optimale Abtastung begrenzt ist. Innerhalb dieses kleinen Abtastabstandes, der oftmals <0,1mm ist, müssen noch in der Regel elektrische Abschirmungen und/oder Schutzschichten in Form von Blechen oder Folien untergebracht werden, so daß raumbeanspruchende Lötstellen zwischen den Sensoren und den Leiterbahnen des elektrischen Verbindungselements auf dieser Oberfläche des Substrats wegen des kleinen Abtastabstandes und des Platzbedarfs der Abschirmungen und/oder Schutzschichten ausgeschlossen sind.

Der Erfindung liegt die Aufgabe zugrunde, bei einer Sensoranordnung eine einfache elektrische Verbindung zwischen den Sensoren und den Kontaktstellen einer Leiterplatte ohne Raumbedarf auf der Oberfläche eines Substrats anzugeben.

Diese Aufgabe wird erfindungsgemäß durch die kennzeichnenden Merkmale des Anspruches 1 gelöst.

Die mit der Erfindung erzielten Vorteile bestehen insbesondere darin, daß durch die gemeinsame Integration der Sensoren und der Leiterbahnen eines ersten Teils des elektrischen Verbindungselements auf dem Substrat auf einfache und kostengünstige Weise eine elektrische Verbindung zwischen den Sensoren und den Leiterbahnen ermöglicht wird, die wegen ihres planaren Aufbaues keinerlei Raumbedarf aufweist, so daß der Abtastabstand zwischen der Oberfläche der Sensoren und der Oberfläche der Meßteilung uneingeschränkt zur Verfügung steht. Die Strukturierung und der Schichtaufbau der Sensoren und der integrierten Leiterbahnen erfolgen in einer Ebene und sind daher problemlos ausführbar. Diese elektrische Verbindung zwischen den Sensoren und den Leiterbahnen ist durch den gemeinsamen Schichtaufbau intermetallisch und daher beständig und ohne Fehlstellen, die bei Lötungen nicht ganz auszuschließen sind; ein zusätzlicher Verbindungsaufwand ist nicht mehr erforderlich. Die vorgeschlagene Sensoranordnung mit dem elektrischen Verbindungselement läßt sich in kostenreduzierender Weise als Mehrfachnutzen fertigen.

Vorteilhafte Weiterbildungen der Erfindung sowie ein Verfahren zur Herstellung einer solchen Sensoranordnung entnimmt man den Ansprüchen 2 bis 10.

Ausführungsbeispiele der Erfindung werden anhand der Zeichnung näher erläutert.

Es zeigen
- Figur 1a-c: Verfahrensschritte zur Herstellung einer Sensoranordnung auf einem Substrat mit einem elektrischen Verbindungselement und dessen Verbindung mit Kontaktstellen einer Leiterplatte und
- Figur 2: eine perspektivische Ansicht der Sensoranordnung auf dem Substrat mit dem elektrischen Verbindungselement.

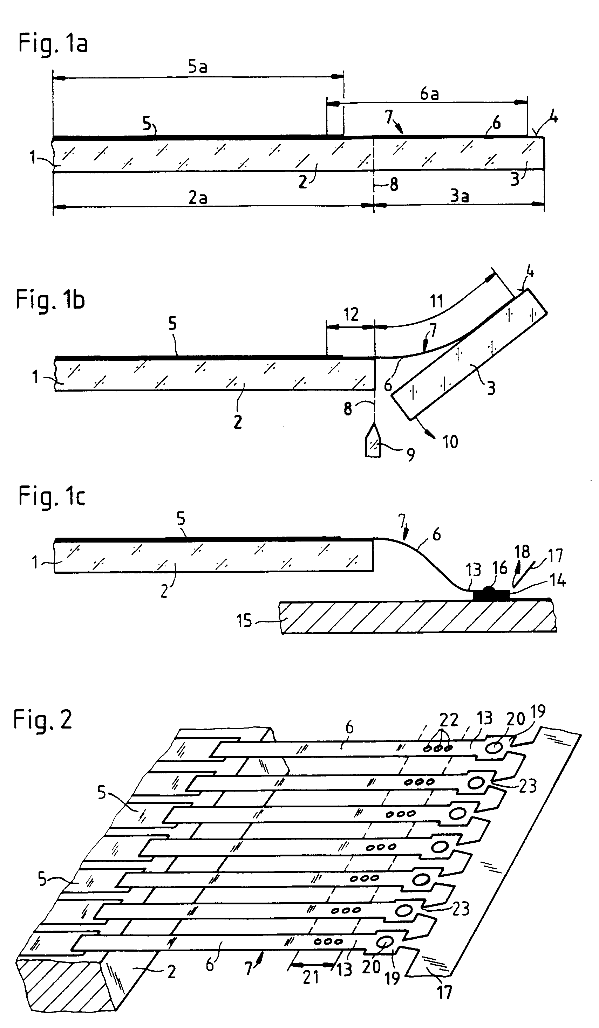

In den Figuren 1a-c sind Verfahrensschritte zur Herstellung einer Sensoranordnung auf einem Substrat mit einem elektrischen Verbindungselement und dessen Verbindung mit Kontaktstellen einer Leiterplatte dargestellt. Ein Ausgangssubstrat 1 weist einstückig ein eigentliches Substrat 2 mit einem Bereich 2a und ein erweitertes Substrat 3 mit einem Bereich 3a auf. Auf einer Oberfläche 4 des Ausgangssubstrats 1 werden planare Sensoren 5 mit einem Bereich 5a und Leiterbahnen 6 mit einem Bereich 6a eines elektrischen Verbindungselements 7 in gemeinsamer durchgehender Struktur in integrierter Form erzeugt (Figur 1a).

Das Ausgangssubstrat 1 wird an der Grenzlinie 8 zwischen dem eigentlichen Substrat 2 und dem erweiterten Substrat 3 mittels eines Werkzeugs 9 angeritzt und gebrochen; anschließend wird das erweiterte Substrat 3 vom eigentlichen Substrat 2 abgetrennt und in Pfeilrichtung 10 von den Leiterbahnen 6 eines zweiten Teils 11 des elektrischen Verbindungselements 7 abgezogen. Die Leiterbahnen 6 eines ersten Teils 12 des elektrischen Verbindungselements 7 bleiben in integrierter Verbindung mit den Sensoren 5 auf dem eigentlichen Substrat 2 haften (Figur 1b).

Anschließend werden die freien Enden 13 der freitragenden Leiterbahnen 6 des zweiten Teils 11 des elektrischen Verbindungselements 7 mit zugehörigen externen Kontaktstellen 14 einer Leiterplatte 15 durch Lötstellen 16 verbunden (Figur 1c).

In Figur 2 ist eine perspektivische Ansicht der Sensoranordnung mit den Sensoren 5 auf dem eigentlichen Substrat 2 und mit dem Verbindungselement 7 gezeigt. Die freitragenden Leiterbahnen 6 des zweiten Teils 11 des elektrischen Verbindungselements 7 weisen an ihren freien Enden 13 einen gemeinsamen Rahmen 17 auf, der nach der Verbindung der freien Enden 13 mit den zugehörigen Kontaktstellen 14 der Leiterplatte 15 entfernt wird (Pfeil 18 in Figur 1c); zu diesem Zweck sind Sollbruchstellen 23 vorgesehen.

Vorzugsweise sind die freien Enden 13 der freitragenden Leiterbahnen 6 mit einem verbreiterten Kontaktbereich 19 versehen, der wenigstens eine Perforation 20 zur Aufnahme eines Lötmittels aufweist. Zusätzlich besitzen die freitragenden Leiterbahnen 6 vor ihren freien Enden 13 einen Fixierbereich 21 mit wenigstens einer Perforation 22, um die freitragenden Leiterbahnen 6 in nicht gezeigter Weise auf der Leiterplatte 15 aus Stabilitätsgründen durch klebtechnischen Formschluß zusätzlich mechanisch zu befestigen.

Für das Ausgangssubstrat 1 sind spröde Materialien geeignet, die sich entlang einer Kerbritzung durch Bruch trennen lassen, wie z.B. Glas, Quarz, Keramik, Polymethylenacrylat etc.

Als Materialien für das Verbindungselement 7 werden beispielsweise Au, Ag, Cu, Ni oder Schichtkombinationen dieser Metalle verwendet, deren Dicke je nach Bedarf variiert werden kann.

Gegebenenfalls können die freitragenden Leiterbahnen 6 des zweiten Teils 11 des Verbindungselements 7 in nicht gezeigter Weise mit wenigstens einer gemeinsamen Folie - insbesondere einer selbstklebenden Isolierfolie - zur Ausbildung eines Flachkabels versehen werden.

Die Konfiguration der freitragenden Leiterbahnen 6 des zweiten Teils 11 des Verbindungselementes 7 erfolgt nach der jeweiligen Lage der externen Kontaktstellen 14 der Leiterplatte 15.

## Patentansprüche

1. Sensoranordnung auf einem Substrat, bei der die Sensoren über Leiterbahnen eines elektrischen Verbindungselementes mit externen Kontaktstellen verbunden sind, insbesondere bei einer Positionsmeßeinrichtung, deren Abtasteinheit das Substrat mit der Sensoranordnung zur Abtastung einer Meßteilung enthält, dadurch gekennzeichnet, daß das Substrat (2) die Sensoren (5) und in integrierter Form die mit den Sensoren (5) elektrisch verbundenen Leiterbahnen (6) eines ersten Teils (12) des Verbindungselements (7) aufweist und daß diese Leiterbahnen (6) in einem zweiten Teil (11) des Verbindungselements (7) das Substrat (2) freitragend überragen.

2. Sensoranordnung nach Anspruch 1, dadurch gekennzeichnet, daß die freitragenden Leiterbahnen (6) des zweiten Teils (11) des Verbindungselements (7) über Sollbruchstellen (23) mit einem gemeinsamen Rahmen (17) verbunden sind.

3. Sensoranordnung nach Anspruch 1, dadurch gekennzeichnet, daß die freitragenden Leiterbahnen (6) des zweiten Teils (11) des Verbindungselements (7) an ihren freien Enden (13) jeweils einen verbreiterten Kontaktbereich (19) aufweisen.

4. Sensoranordnung nach Anspruch 3, dadurch gekennzeichnet, daß der verbreiterte Kontaktbereich (19) wenigstens eine Perforation (20) aufweist.

5. Sensoranordnung nach Anspruch 1, dadurch gekennzeichnet, daß die freitragenden Leiterbahnen (6) des zweiten Teils (11) des Verbindungselements (7) vor ihren freien Enden (13) jeweils wenigstens einen Fixierbereich (21) aufweisen.

6. Sensoranordnung nach Anspruch 5, dadurch gekennzeichnet, daß der Fixierbereich (21) wenigstens eine Perforation (22) aufweist.

7. Sensoranordnung nach Anspruch 1, dadurch gekennzeichnet, daß Substrat (2) aus einem spröden Material z.B. Quarz, Glas, Keramik, Polymethylenacrylat etc. besteht.

8. Sensoranordnung nach Anspruch 1, dadurch gekennzeichnet, daß das Verbindungselement (7) aus Au, Ag, Cu, Ni oder Schichtkombinationen dieser Metalle besteht.

9. Sensoranordnung nach Anspruch 1, dadurch gekennzeichnet, daß die freitragenden Leiterbahnen (6) des zweiten Teils (11) des Verbindungselements (7) mit wenigstens einer gemeinsamen Folie versehen sind.

10. Verfahren zur Herstellung einer Sensoranordnung auf einem Substrat mit einem elektrischen Verbindungselement nach Anspruch 1, gekennzeichnet durch folgende Verfahrensschritte:
a) Ein Ausgangssubstrat (1) mit dem eigentlichen Substrat (2) und einem erweiterten Substrat (3) wird einstückig erstellt;
b) die Sensoren (5) und die Leiterbahnen (6) des elektrischen Verbindungselements (7) werden in gemeinsamer durchgehender Struktur auf einer Oberfläche (4) des Ausgangssubstrats (1) in integrierter Form erzeugt;
c) das erweiterte Substrat (3) wird sodann vom eigentlichen Substrat (2) abgetrennt und vom anhaftenden zweiten Teil (11) des Verbindungselements (7) abgezogen;
d) anschließend werden die freitragenden Leiterbahnen (6) des zweiten Teils (11) des Verbindungselements (7) zur nachfolgenden Verbindung mit den externen Kontaktstellen (14) präpariert.

## Claims

1. Sensor assembly on a substrate, in which the sensors are connected by conductor strips of an electrical connecting element to external contact points, in particular in a position measuring device of which the scanning unit contains the substrate with the sensor assembly for scanning a measuring graduation, characterised in that the substrate (2) comprises the sensors (5) and in integrated form the conductor strips (6) of a first portion (12) of the connecting element (7), which strips (6) are electrically connected to the sensors (5), and in that these conductor strips (6) in a second portion (11) of the connecting element (7) protrude in cantilever fashion beyond the substrate (2).

2. Sensor assembly according to claim 1, characterised in that the cantilever conductor strips (6) of the second portion (11) of the connecting element (7) are connected by predetermined breaking points (23) to a common frame (17).

3. Sensor assembly according to claim 1, characterised in that the cantilever conductor strips (6) of the second portion (11) of the connecting element (7) at their free ends (13) comprise in each case a wider contact region (19).

4. Sensor assembly according to claim 3, characterised in that the wider contact region (19) comprises at least one perforation (20).

5. Sensor assembly according to claim 1, characterised in that the cantilever conductor strips (6) of the second portion (11) of the connecting element (7) before their free ends (13) comprise in each case at least one fixing region (21).

6. Sensor assembly according to claim 5, characterised in that the fixing region (21) comprises at least one perforation (22).

7. Sensor assembly according to claim 1, characterised in that the substrate (2) is made of a brittle material e.g. quartz, glass, ceramic, polymethylene acrylate, etc.

8. Sensor assembly according to claim 1, characterised in that the connecting element (7) is made of Au, Ag, Cu, Ni or layered combinations of these metals.

9. Sensor assembly according to claim 1, characterised in that the cantilever conductor strips (6) of the second portion (11) of the connecting element (7) are provided with at least one common film.

10. Method for the manufacture of a sensor assembly on a substrate with an electrical connecting element according to claim 1, characterised by the following steps:
a) an initial substrate (1) with the actual substrate (2) and an extended substrate (3) is produced in one piece;
b) the sensors (5) and the conductor strips (6) of the electrical connecting element (7) are produced in integrated form in a common, continuous structure on one surface (4) of the initial substrate (1);
c) the extended substrate (3) is then separated from the actual substrate (2) and pulled off the adhering second portion (11) of the connecting element (7);
d) then the cantilever conductor strips (6) of the second portion (11) of the connecting element (7) are prepared for subsequent connection to the external contact points (14).

## Revendications

1. Agencement de capteurs sur un substrat, dans lequel les capteurs sont reliés à des bornes extérieures par l'intermédiaire de pistes conductrices appartenant à un élément de liaison électrique, en particulier dans un dispositif de mesure de position, dont l'unité de lecture comprend le substrat avec l'agencement de capteurs destiné à la lecture d'une graduation de mesure, caractérisé par le fait que le substrat (2) comporte les capteurs (5) et, sous une forme intégrée, les piste conductrices (6) reliées électriquement aux capteurs (5) d'une première partie (12) de l'élément de liaison (7) et par le fait que lesdites pistes conductrices (6), dans une deuxième partie (11) de l'élément de liaison (7), s'étendent en porte-à-faux au-dessus du substrat (2).

2. Agencement de capteurs selon la revendication 1, caractérisé par le fait que les pistes conductrices (6) en porte-à-faux de la deuxième partie (11) de l'élément de liaison (7) sont reliées à un cadre (17) commun par l'intermédiaire de zones (23) destinées à la rupture.

3. Agencement de capteurs selon la revendication 1, caractérisé par le fait que les pistes conductrices (6) en porte-à-faux de la deuxième partie (11) de l'élément de liaison (7) présentent chacune à leur extrémité libre (13) une partie de contact (19) élargie.

4. Agencement de capteurs selon la revendication 3, caractérisé par le fait que la partie de contact (19) élargie présente au moins un perçage (20).

5. Agencement de capteurs selon la revendication 1, caractérisé par le fait que les pistes conductrices (6) en porte-à-faux de la deuxième partie (11) de l'élément de liaison (7) présentent chacune en amont de leur extrémité libre (13) au moins une zone de fixation (21).

6. Agencement de capteurs selon la revendication 5, caractérisé par le fait que la zone de fixation (21) présente au moins un perçage (22).

7. Agencement de capteurs selon la revendication 1, caractérisé par le fait que le substrat (2) est constitué d'un matériau fragile, par exemple de quartz, de verte, de céramique, de polyacrylate de méthyle, etc....

8. Agencement de capteurs selon la revendication 1, caractérisé par le fait que l'élément de liaison (7) est en Au, Ag, Cu, Ni ou en une combinaison de couches de ces métaux.

9. Agencement de capteurs selon la revendication 1, caractérisé par le fait que les pistes conductrices (6) en porte-à-faux de la deuxième partie (11) de l'élément de liaison (7) sont pourvues d'au moins un film commun.

10. Procédé de fabrication d'un agencement de capteurs sur un substrat avec un élément de liaison électrique selon la revendication 1, caractérisé par les étapes suivantes:
a) on produit un substrat (1) de base monobloc qui comprend le substrat (2) à proprement parler et une partie (3) de substrat additionnelle;
b) on produit les capteurs (5) et les pistes conductrices (6) de l'élément de liaison (7) sous une forme intégrée en tant que structure commune continue sur une surface (4) du substrat de base (1);
c) on sépare la partie (3) de substrat additionnelle et on ma décolle de la deuxième partie (11) de l'élément de liaison qui adhère sur celle-ci;
d) enfin on prépare les pistes conductrices (6) en porte-à-faux de la deuxième partie (11) de l'élément de liaison (7) en vue de la liaison ultérieure avec les bornes de connexion (14) extérieures.
